Europäisches Patentamt

European Patent Office

Office européen des brevets

(11) Publication number: **0 310 332**
**A2**

# (12) EUROPEAN PATENT APPLICATION

(21) Application number: 88308935.1

(51) Int. Cl.⁴: **H01L 39/24 , H01L 39/14**

(22) Date of filing: 27.09.88

(30) Priority: 28.09.87 US 101821
28.09.87 US 101771
28.09.87 US 101818
28.09.87 US 101819
28.09.87 US 101820

(43) Date of publication of application:
05.04.89 Bulletin 89/14

(84) Designated Contracting States:
AT BE CH DE FR GB IT LI LU NL SE

(71) Applicant: ARCH DEVELOPMENT
CORPORATION
Argonne National Laboratory Building 207
Argonne Illinois 60439(US)

(72) Inventor: Capone, Donald W.
563, W. Briarcliff
Bolingbrook Illinois 60439(US)
Inventor: Poeppel, Roger B.
67, Stephanie Lane
Glen Ellyn Illinois 60137(US)
Inventor: Dusek, Joseph T.
1710, Maple Avenue
Downers Grove Illinois 60515(US)
Inventor: Tolt, Thomas
5057, Hampton Drive
North Olmsted Ohio 44070(US)
Inventor: Dunlap, Bobby D.
500, Clover Lane
Bolingbrook Illinois 60439(US)
Inventor: Veal, Boyd
1117, 86th Street
Downers Grove Illinois 60439(US)

(74) Representative: Newby, Martin John et al
J.Y. & G.W. Johnson Furnival House 14-18
High Holborn
London WC1V 6DE(GB)

(54) Preferential orientation of metal oxide superconducting materials.

(57) A polycrystalline metal oxide such as $YBa_2Cu_3O_{7-x}$ (where $0 > X > 0.5$) exhibits superconducting properties and is capable of conducting very large current densities. By aligning the two-dimensional Cu-O layers which carry the current in the superconducting state in the a- and b-directions, i.e., within the basal plane, a high degree of crystalline axes alignment is provided between adjacent grains permitting the conduction of high current densities, i.e., on the order of $10^4$ - $10^5$ amps/cm$^2$.

EP 0 310 332 A2

# PREFERENTIAL ORIENTATION OF METAL OXIDE SUPERCONDUCTING MATERIALS

This invention relates generally to the fabrication and composition of superconducting materials and is particularly directed to the preferential orientation of the crystals of a superconducting material to permit the conduction of large current densities.

Certain metals, alloys, and chemical compounds known as superconductors exhibit zero electrical resistivity and complete diamagnetism at very low temperatures and magnetic fields. The transition of a metal from normal electrical conducting properties to superconducting properties depends primarily on (1) the temperature and (2) the magnetic field at the surface of the metal. The superconductive state of the metal exists for temperatures less than its characteristic critical temperature, $T_c$. The most practical superconducting materials exhibit very low critical temperatures, i.e., on the order of 4-23° K. However, recent developments have produced new superconducting materials, based on oxides, having critical temperatures on the order of 100° K.

Superconductors also exhibit a characteristic critical electric current density, $J_c$, measured in amps/cm². By increasing the current density in a superconducting material to its $J_c$ characteristic value, it can be driven into a normal conducting state. Thus, the current density at which this transition occurs is termed the conductive material's critical current density. It is of course desirable for a superconductor to have a high critical current density to allow it to conduct large currents while remaining superconductive.

In practical Type II superconductors efforts to increase the critical current density have involved the incorporation of microstructural defects in the material. A magnetic field applied to the superconductor penetrates the material in the form of small bundles, or vortices, of magnetic flux which can move about within the material as it conducts current. Movement of these magnetic vortices is a dissipative process characterized by resistive heating and thus represents a limitation in the material's current carrying capacity. Incorporation of the aforementioned microstructural defects within the material prevents the magnetic vortices from moving within the superconductor in response to current flowing therein. By preventing the movement of these magnetic vortices, the material's critical current density can be substantially increased before the material assumes normal, non-superconducting current conducting operation.

The class of metal oxide superconductors unfortunately exhibit very small critical current densities. For example, these materials typically have a critical current density in the presence of magnetic fields on the order of 5-10 amps/cm², while other practical superconductors typically are capable of supporting current densities on the order of 10,000-100,000 amps/cm². As a result, these metal oxide materials have heretofore been of limited use in superconducting applications. Recent investigations have indicated that low critical electric current density values are not an intrinsic problem with metal oxide superconductors, since single crystal, thin film metal oxide superconducting materials have been produced which are capable of supporting very large current densities.

The present invention addresses the aforementioned limitations of prior art metal oxide superconducting materials by allowing such materials to be used in very high current density applications. By aligning the crystalline axes of these materials in single crystal, powder form along preferential directions so as to compensate for the anisotropy of the superconducting properties of these materials, these metal oxide superconductors are rendered capable of supporting very large current densities.

Accordingly, it is an object of the present invention to provide a large current density conducting capability in a superconducting metal oxide polycrystalline material.

It is another object of the present invention to substantially increase the electrical conductivity of a polycrystalline oxide metal oxide conductor by preferential orientation of its crystal structure.

Yet another object of the present invention is to increase the current carrying capacity of a ceramic superconducting material by rendering it in the form of a single crystal, flake-like powder and aligning its crystal axes along preferential directions.

Accordingly, the present invention contemplates aligning the grains of an orthorhombic metal oxide superconductor such that its a- and b-directions, i.e., within the basal plane of each of the crystals, are aligned to permit the polycrystalline metal oxide superconductor to support very large critical current densities.

2

## BRIEF DESCRIPTION OF THE DRAWINGS

FIG. 1 is a simplified schematic diagram of a tape casting apparatus for use in the preferential orientation of the crystal particles of a metal oxide superconducting material in accordance with the present invention;

FIG. 2 is a simplified schematic diagram of a slip casting apparatus for use in the preferential orientation of the crystal particles of a metal oxide superconducting material in accordance with the present invention;

FIG. 3 is an extrusion arrangement for use in the preferential orientation of the crystal particles of a metal oxide superconducting material in accordance with the present invention;

FIG. 4 illustrates the orientation of a crystal particle of metal oxide superconducting material in accordance with the present invention;

FIG. 5 is a simplified schematic diagram of an arrangement for applying an acoustic plane wave to a superconducting metal oxide ceramic slip in accordance with the present invention; and

FIG. 6 is a simplified schematic diagram illustrating the interaction of an electromagnetic field upon a disc-like crystal particle of a metal oxide superconducting material in aligning the particles along a common direction.

Initial measurements on polycrystalline samples of oxide superconductors such as $YBa_2Cu_3O_{7-x}$ (where 0 X 0.5) have shown that the current carrying capacity of these materials is not large enough to allow these materials to serve in practical applications. For example, recent measurements have indicated that these materials are only capable of supporting current densities on the order of 100-1000 amps/cm$^2$ in zero magnetic field. This current carrying capacity is clearly inadequate from a practical standpoint when compared with critical current densities on the order of 10,000-100,000 amps/cm$^2$ generally available in other superconducting materials. In addition, these limited current densities observed in metal oxide superconductors of this type are substantially reduced (as much as 100 times less) by the application of relatively small magnetic fields. Recent work performed at International Business Machines (IBM) as described at the American Ceramic society Meeting in Pittsburgh, Pennsylvania, in April 1987 indicates that this is not an intrinsic problem with these metal oxide superconducting materials, since textured, thin-film materials have been produced which are capable of supporting very large current densities (> 100,000 amps/cm$^2$). The aforementioned IBM work further indicates that the a- and b-directions, i.e., within the basal plane, of the orthorhombic $YBa_2Cu_3O_{7-x}$ are capable of supporting on the order of 30-100 times the critical current density which can be achieved in the c-direction, i.e., normal to the basal plane.

The reason for this inability of bulk metal oxide superconductors to support the large current densities necessary in virtually all practical applications appears to be a lack of alignment between adjacent grains of $YBa_2Cu_3O_{7-x}$ which carry the current in the superconducting state. This lack of alignment between adjacent grains is believed to restrict current transport to that available only by means of Josephson tunnelling and thus represents a severe limitation on current handling capability in magnetic fields. Evidence to support this finding can be found in both the small current densities and the strong field dependence of the conductivity of these materials.

This problem is avoided in the present invention by orienting the crystalline axes of different grains of these metal oxide superconducting materials along common directions to facilitate current transport across these grain boundaries. Polycrystalline oxide superconductors in accordance with the present invention are comprised of particles each of which is essentially a single crystal and which may be synthesized by either (1) growing bulk single crystals and grinding these single crystals into a powder, or (2) carrying out long-term annealing of powder samples of these polycrystalline metal oxide materials at temperatures near the melting temperature in order to promote large single crystal grain growth, followed by the grinding of these materials into fine powders.

In one approach leading to the present invention, a metal oxide superconductor such as $YBa_2Cu_3O_{7-x}$ - (where 0 < X < 0.5) is provided in powder form using any one of several conventional methods well known to those skilled in the relevant arts. This polycrystalline powder is then pressed into a compact form such as in the shape of pellets by means of a hydrostatic press in a conventional manner. The compacted polycrystalline powder is then heated to a temperature on the order of its melting point, i.e., to a temperature in the range of 950°-1000° C for yttrium barium copper oxide which has a melting point of approximately 1025°C. The metal oxide material is sintered at these high temperatures for an extended period of time, e.g., on the order of 20-60 hours, in order to induce large grain growth. After sintering the metal oxide material at the aforementioned temperatures for the stated period of time, grains on the order of 100 microns in diameter are produced in the compacted crystal structure.

The sintered, large grained metal oxide crystal structure is then ground to a powder comprised of single crystal particles. The thus formed superconducting powder has a flake-like morphology such that the c-axis of the individual crystals is aligned parallel to the short dimension of the disc-like flake. The metal oxide particles thus take on the general form of a flattened disc where the a- and b-directions are in the plane of the disc and the c-axis is oriented generally perpendicular to the plane of the disc. All of the crystal particles thus have generally the same orientation. Tapes and/or wires processed from these powders have the a- and b-directions of the crystal particles oriented along the planes of the Cu and O conducting layers throughout the bulk of the wire or tape and thus permit a large critical current to be conducted within the conductor. In grinding the superconducting crystals down to a size much less than the original grain size, the compact superconducting metal oxide material is cleaved along the crystal axes resulting in platelets, or small flat bodies having the aforementioned disc-like shape. The high critical current density axes of these platelets lies in the plane of its disc-like shape.

In order to improve grain growth, impurities may be added to the metal oxide crystal material to produce larger grained structures. The addition of barium cuprate ($BaCuO_2$) to the metal oxide crystal material provides an excess of barium oxide and copper oxide, which form a low temperature eutectic with a melting temperature of about 880°C lower than the sintering temperatures used. The low melting points of the barium oxide and copper oxide eutectic allow for increased diffusion within the metal oxide powder mixture producing larger grain growth. The other approach referred to above in producing the metal oxide crystal powder, i.e., growing bulk single crystals and grinding them into a powder, may be accomplished by growing each crystal from a similar melt using a molten bath. The difference between the two techniques lies in the amount of second phases one wishes to tolerate. In the molten bath technique large amounts of second phase must be removed from the mixture in order to obtain the desired $YBa_2Cu_3O_{7-x}$ crystals.

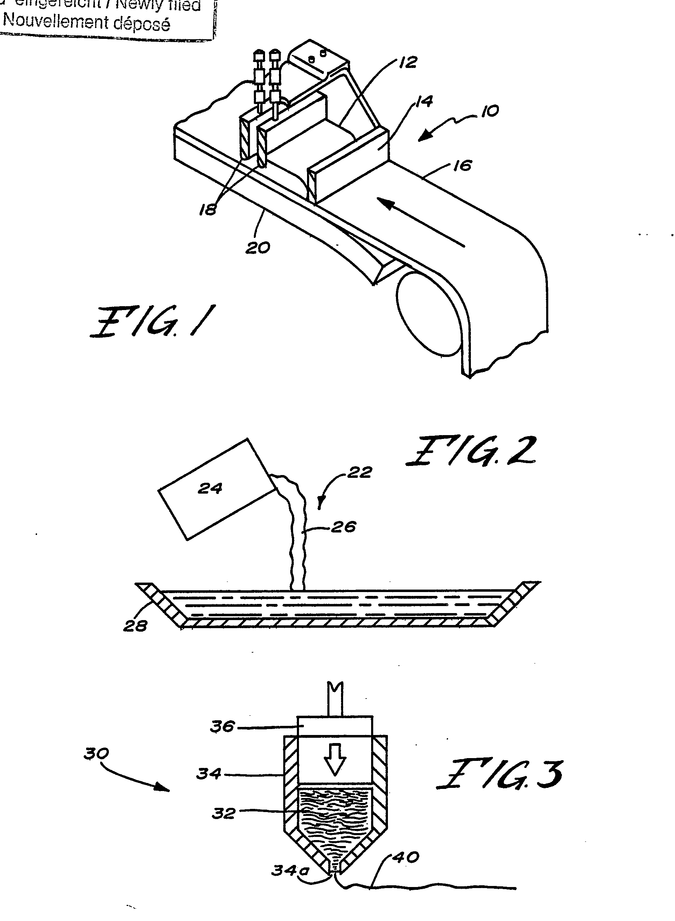

After producing the metal oxide crystal powders in which the particles are predominantly single crystallites, various approaches may be taken to orient the crystal particles along common axes. For example, as shown in FIG. 1, a tape casting apparatus 10 may be used in aligning the crystal particles along common axes. In the tape casting apparatus 10, a slip 12, comprised of a suitable mixture of single crystal powder, binders and plasticizers, is spread onto a tempered glass bed or other suitable flat surface 20 with a doctor blade 18 which produces the desired thickness. As the slip is drawn beneath the doctor blade 18, the individual crystal particles contained within are oriented such that their c-axes are aligned generally perpendicular with the plane of the tape. This is due to the flake-like discs aligning parallel to the plane of the tape. The application of a magnetic field would greatly enhance this alignment technique.

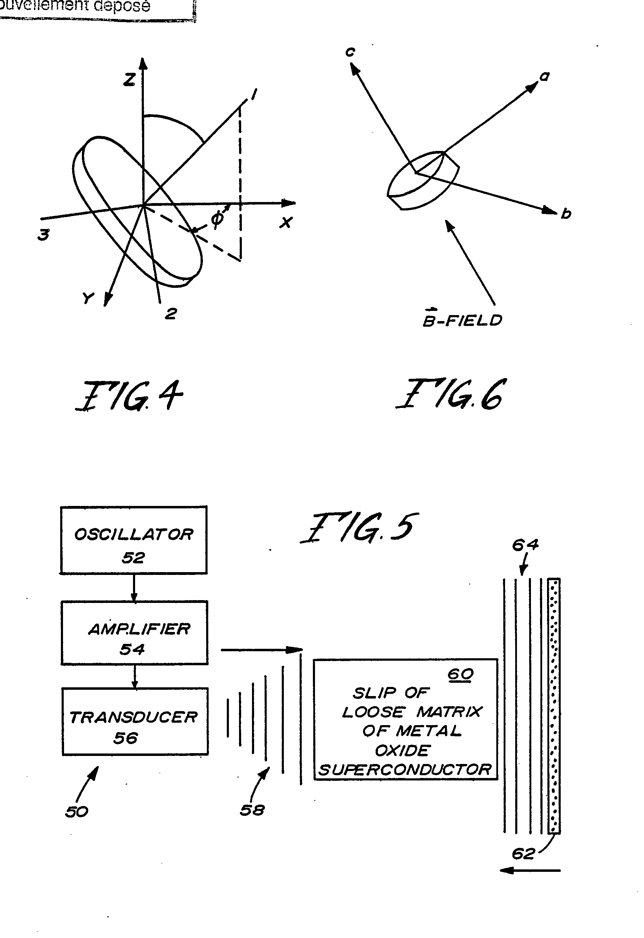

Referring to FIG. 2, there is shown another alternative approach which can be used for the preferential orientation of the individual crystal particles of the metal oxide powder. In the approach illustrated in FIG. 2, a slip casting arrangement 22 includes a plaster mold 28 into which a mixture 26 of the metal oxide powder crystals and a binder and solvent are poured from a container 24. The plaster mold 28 absorbs the binder and solvent leaving only the metal oxide crystals remaining in the plaster mold. Because of the plate-like shape of the individual crystals and their tendency not to remain in an on-end orientation, the crystal particles remaining in the plaster mold 28 are generally aligned in a flat orientation with their longer c-axis aligned generally horizontal. It should be noted here that for all of these descriptions of process techniques, alignment occurs in the absence of the magnetic field. However, it is greatly enhanced by the application of a magnetic field.

Referring to FIG. 3, there is shown yet another arrangement for orienting the metal oxide crystals along a preferential axis. In the approach of FIG. 3, an extrusion apparatus 30 includes a container 34 within which a partially dried slip containing the metal oxide powder 32 having a putty-like texture is disposed. The container 34 includes a small tapered aperture 34a on a lower portion thereof. The downward displacement of a pusher element 36 against the slip 32 within the container 34 forces the mixture out of the container's aperture 34a. The thus extruded metal oxide powder is in the form of a wire 40. This physics producing alignment in the tape casting techniques is the same in this technique and hence one can expect orientation using extrusion as well.

Further in accordance with the present invention, in achieving preferential orientation of the metal oxide crystals, an acoustic plane wave, or a pressure wave is applied to a dispersion in liquid of superconducting metal oxide powder crystals. The powder-liquid mixture may be produced by any one of the aforementioned techniques or by other procedures. The pressure wave is applied to the powder-liquid mixture before it is sintered to a ceramic form. The manner in which a pressure wave orients crystal particles along a preferred direction is discussed in the following paragraphs. In this discussion, the metal oxide crystal particles are considered to be in the form of flat discs which closely approximates their actual configuration.

As described in "Theories of Birefringence" by N. C. Hilyard and H. C. Jerrard, Journal of Applied Physics, Vol. 33, No. 12, pp. 3470-3479, Dec. 1962, acoustic double refraction has been observed in solutions of nonspherical particles for frequencies between 2540 and 5240 kHz and with vanadium pentoxide in water and glycerin for both progressive and standing waves. Pronounced relaxation effects were observed.

Assuming that because of the radiation pressure set up in a solution by the passage of acoustic waves, colloidal particles or large molecules are subjected to a turning torque that attempts to align them with respect to the acoustic field. They in fact behave as Rayleigh discs. The distribution of the particles was obtained by considering the potential energy resulting from the torque.

Another approach has considered the solution to be monodisperse and assumed the particles to be identical, uncharged, rigid, homogeneous ellipsoids of revolution which, if an appropriate value is taken for the axial ratio, may be considered as thin discs as shown in FIG. 4. Only dilute solutions were treated so that interacting forces were negligible. The axes of the ellipsoid were taken to coincide with the directions of principal polarizabilities. The forces acting on the particles were taken to be the time average torque M tending to orientate them and the force due to Brownian motion. By application of Debye's theory, the number of particles which at a given time have their major axis 01 in a solid angle $d\Omega$ is $Fd\Omega$ , where the distribution function F is given by

$$R\frac{\partial F}{\partial t} = \frac{1}{\sin\theta}\frac{\partial}{\partial\theta}\left[\sin\theta\left(kT\frac{\partial F}{\partial\theta} - \overline{M}F\right)\right] . \qquad (1)$$

In this equation R is the moment required to give the particle unit angular velocity about an axis perpendicular to 01. It is related to the rotary diffusion constant D by $D = kT/R$, where k and T are Boltzmann's constant and the absolute temperature, respectively. If, due to the torque $\overline{M}$ , the particle acquires a potential U, then

$\overline{M} = R\partial e/\partial t = -\partial u/\partial e.$ (2)

In the steady state, $\partial F/\partial t = 0$, so by Eq. (1),

$kT(\partial F/\partial\theta) = \overline{M} F = -(\partial U/\partial\theta)F$

whence

$F = C'e^{-U/kT}.$ (4)

The constant $C'$ is determined by assuming that $\int Fd\Omega = 1$ In order to determine F it is necessary to find a value for $\overline{M}$ . by King. For a disc of radius a, volume V and density $\rho_1$ in a liquid of density $\rho_0$ subjected to a plane standing acoustic wave with a given velocity field, then provided $2\pi a \ll$ the acoustic wavelength $\lambda$,

$\overline{M} = -\frac{3}{2}\rho_0 a^3 A^2 \sin 2\theta [K \sin^2 kz - L \cos^2 kz],$ (5)

where

$$K = \frac{m(5+2k^2a^2\cos^2\theta)}{5m+m_0(5+k^2a^2)}$$

and

$$L = \frac{2}{15}\frac{I_1 k^2 a^2\cos 2\theta}{I_1 + I_0}.$$

The negative sign indicates that $\overline{M}$ tends to reduce $\theta$. z is the distance from a node, m is the mass of the particle minus the mass of liquid displaced, and $m_0$, $I_1$, and $I_0$ are given by

$m_0 = (8/3)\rho_0 a^3, I_0 = (2/15)m_0 a^2, I_1 = \frac{1}{4} ma^2.$

The values of $\overline{M}$ at a velocity node (z-0) and a velocity antinode ($z = \lambda/4$), respectively, are given by

$\overline{M}_m = (2L/3)\rho_0 a^3 A^2 \sin 2\theta$

and

$\overline{M}_a = -(2K/3)\rho_0 a^3 A^2 \sin 2\theta,$

so that

$$\left|\frac{\overline{M_m}}{M_a}\right| = \frac{L}{K} \doteq \frac{(ka)^2}{15} \doteq \frac{4\pi^2 a^2}{15\lambda^2}.$$

This means that $\overline{M}_a$ is predominant and if $(ka)^2$ is small, it is given by

$\overline{M}_a \doteq \frac{2}{3}\rho_0 a^3 A^2 (m/m + m_0) \sin 2\theta$

This torque also applies to a disc in a progressive wave. The energy density $\overline{E}$ of the acoustic field may be introduced so that

$\overline{M}_m \frac{4}{3} a^3 E(m_a/m + m_0) \sin 2\theta$ (6)

$= \_\_ B \sin 2\theta$ (7)

where, if V is the volume of the disc,

$$B = 4a^2 E \left[\frac{V(\rho_l - \rho_0)}{3V(\rho_l - \rho_0) + 8\rho_0 a^3}\right] \qquad (8)$$

and if the thickness of the disc is t then $V = \pi a^2 t$. By Eqs. (2) and (8)

$U = \int B \sin 2\theta = -\frac{1}{2} B \cos 2\theta + C.$ (9)

where C is a constant and U has a minimum value of $C - B/2$ when $\theta = 0$ or $\pi/2$ according to whether $B > 0$ or $B < 0$, respectively. Thus on the application of the field, the disk attempts both in a progressive and a standing wave to attain this orientation. It is opposed by thermal motion so that a temperature dependent equilibrium is established with a distribution function determined by Eqs. (4) and (9).

Referring to FIG. 5, there is shown in simplified schematic diagram form a pressure wave generating arrangement 50 for directing a pressure wave upon a slip 60 of metal oxide superconducting crystals dispersed in a liquid for orienting the crystal particles along a preferred direction. The pressure wave generating arrangement 50 includes an oscillator 52 which generates and provides an alternating signal to an amplifier 54. Amplifier 54 amplifies the alternating output of the oscillator 52 for driving a transducer 56 which converts the electric signal to a pressure wave 58 which is directed onto the powder-liquid slip 60 of the metal oxide superconducting crystal particles. The pressure waves 58 travel in the direction of the upper arrow in FIG. 5 and align the crystal particles within the slip 60 along a preferred direction. The arrangement of FIG. 5 further includes a wave reflector 62 which reflects the incident pressure waves and directs them back in the form of a reflected pressure wave 64 in the direction of the lower arrow in FIG. 5. By positioning the slip 60 between the transducer 56 and the reflector 62, a standing pressure wave is established across the slip of the metal oxide superconductor in applying a greater torque to the crystal particles for orienting them along a preferred direction.

The slip 60 of the metal oxide superconducting crystal particles is comprised of a solvent and a dispersing agent within which the crystal particles are dispersed. An example of a solvent for use in forming the slip 60 is xylene butyl alcohol. An example of a dispersing agent for use in the powder dispersed in liquid slip is the phosphate esther Emphos PS-21A which prevents clumping of the crystal particles by causing the individual particles from making intimate contact with one another. The liquid portion of the slip 60 of the metal oxide superconducting crystal particles may be removed by either evaporation or by depositing the slip into a plaster mold which absorbs the liquid. After the liquid is removed from the slip 60, the metal oxide superconductor is converted to ceramic form by sintering.

There has thus been shown an improved metal oxide superconducting material with enhanced current-carrying capability. The metal oxide material is comprised of a powder wherein each of the particles is a single crystal having an orthorhombic structure and an anisotropic conductive characteristic. Each of the crystals is aligned along a preferential direction such that the desired direction of current conduction is aligned with the high critical current layers of the superconductor crystal structure. The application of a plane pressure wave to a slip of the metal oxide crystal particles causes the preferential orientation of the individual metal oxide crystals along a common axis.

Referring to FIG. 6, there is shown the manner in which the disc-like shaped metal oxide crystal platelets are aligned by a magnetic field in accordance with the present invention. The magnetic field (B-field) is applied in the direction of the larger arrow in FIG. 6. Because the disc-like shaped metal oxide crystals are diamagnetic, wherein the internal magnetic field cancels out the external applied magnetic field in accordance with the Meisner effect, a surface current will be established on the disc-like shaped platelets. The surface current in each of the disc-like crystal particles generates its own magnetic moment which interacts with the applied magnetic field to align the crystal particles with the external applied magnetic field. The alignment assumed by each of the crystal particles relative to the applied magnetic field is shown in FIG. 6 and arises because of the anisotropic superconductivity of the crystal particles. Thus, each of the crystal particles, which is superconducting in its a-, b-plane, is aligned such that the plane of its disc-like shape is oriented perpendicular to the external applied magnetic field. As a result, each of the c-axes of the crystal particles, along which the crystal particle is weakly-superconducting, are aligned parallel to the direction of the applied external magnetic field. In this manner, all of the metal oxide crystal particles are oriented along common axes. Because the metal oxide crystal particles possess a surface current only when in the superconducting state, alignment of the metal oxide crystal particles along common axes by means of an applied magnetic field must be performed while the metal oxide crystal material is in a superconducting state, which is typically at low, or liquid nitrogen temperatures.

The present invention also contemplates using a paramagnetic material at room temperature to align the crystals or by substituting a rare earth material for one of the components of the superconducting metal oxide material one can use the anisotropic paramagnetism of the rare earth compounds to align the crystals. For example, where yttrium barium copper oxide is the superconducting material, substitution of the rare atoms for the yttrium will render the metal oxide material paramagnetic such that its induced internal magnetic field will be aligned with the external applied magnetic field. In this case, the plane of the disc-like shaped crystal particles will be aligned generally with the applied magnetic field in a direction independent of which magnetic rare earth element is chosen. In either case, the application of a magnetic field to the anisotropic superconducting metal oxide crystal particles will result in their common alignment along a preferential direction. In the latter example, various rare earth atoms, such as dysprosium, holmium and erbium, may be substituted for the yttrium in the superconducting metal oxide to permit crystals of this material when reduced to particle-like form to be aligned along common axes with the application of a magnetic field thereto. The magnetic field may be applied to the metal oxide crystal particles dispersed in a liquid by conventional means such as by an electromagnet or permanent magnet.

There has thus been shown an improved metal oxide superconducting material with enhances current-carrying capability. The metal oxide material is comprised of a powder wherein each of the particles is a single crystal having an orthorhombic structure and an anisotropic conductive characteristic. Each of the crystals is aligned along a preferential direction such that the desired direction of current conduction is aligned with the high critical current layers of the superconductor crystal structure. Various mechanical means may be used for the preferential orientation of the individual metal oxide crystals such as slip casting, tape casting, or extrusion.

While particular embodiments of the present invention have been shown and described, it will be obvious to those skilled in the art that changes and modifications may be made without departing from the invention in its broader aspects. For example, while the present invention is described in terms of a superconducting crystal powder comprised of yttrium barium copper oxide, this invention contemplates a superconducting material comprised of virtually any rare earth metal oxide having a crystal structure such as orthorhombic which possesses an anisotropic superconducting characteristic.

## Claims

1. A method of forming a superconducting metal oxide with improved current carrying capacity wherein said superconducting metal oxide has an orthorhombic crystal structure and is anisotropically superconducting having one or more shorter crystal axes along which said metal oxide is superconducting, said method comprising the steps of:
reducing the superconducting metal oxide to a flake-like, powder form, wherein the metal oxide powder is comprised of particles of single crystals; and
orienting said metal oxide single crystal particles along a preferential direction such that said one or more shorter axes of each of said metal oxide crystals are in general alignment.

2. The method of claim 1 wherein said superconducting metal oxide is a rare earth superconducting metal oxide.

3. The method of claim 2 wherein said rare earth superconducting metal oxide is $YBa_2Cu_3O_{7-x}$, where $0<X<0.5$.

4. The method of claim 1 wherein the axes of said metal oxide crystals are along a-, b-, and c-directions. and wherein said a- and b-directions define a basal plane of said crystals within which said metal oxide is superconducting.

5. The method of claim 4 wherein the c-directions of each of said metal oxide crystals are aligned generally parallel.

6. The method of claim 1 further comprising the step of mixing said metal oxide crystal powder with a liquid so as to form a loose matrix of said metal oxide crystals prior to orienting said metal oxide single crystal particles along a preferential direction.

7. The method of claim 6 wherein the step of orienting said metal oxide crystals along a preferential direction includes tape casting the loose matrix of said metal oxide crystals onto a moving support member, the tape casting of the loose matrix of said metal oxide crystals including passing the loose matrix across blade means for orienting the metal oxide crystals along a preferential direction.

8. The method of claim 6 wherein the step of orienting said metal oxide crystals along a preferential direction includes depositing the loose matrix of said metal oxide crystals into a plaster mold and allowing the thus deposited matrix to stand over a period of time. the plaster mold being shallow and the one or more shorter axes of the metal oxide crystals being oriented generally vertically.

9. The method of claim 6 wherein the step of orienting said metal oxide crystals along a preferential direction includes extruding the loose matrix of said metal oxide crystals in the form of a thin strip, the one or more shorter axes of the metal oxide crystals being oriented generally transverse to the direction the loose matrix of metal oxide crystals is extruded, and further comprising the step of depositing the extruded loose matrix of metal oxide as a wire.

10. The method of claim 1 wherein the step of orienting said metal oxide crystals along a preferential direction includes mixing said metal oxide single crystal particles with a slip; rendering said metal oxide single crystal particles mixed in said slip in a superconducting state; and directing a magnetic field onto the mixture of said metal oxide single crystal particles and said liquid in orienting said metal oxide single crystal particles along a preferential direction such that said one or more shorter axes of each of said metal oxide crystals are in general alignment.

11. The method of claim 10 further comprising the step of mixing said metal oxide single crystal particles with a liquid comprised of a solvent and a dispersing agent, and heating the mixture of said metal oxide single crystal particles and said liquid after said metal oxide single crystal particles are aligned to remove the liquid therefrom.

12. The method of claim 10 further comprising the step of mixing said metal oxide single crystal particles with a liquid comprised of a solvent and a dispersing agent, and allowing the liquid to evaporate from the mixture of said metal oxide single crystal particles and said liquid after said metal oxide single crystal particles are aligned along said preferential direction.

13. The method of claims 11 and 12 further comprising the step of sintering the mixture of said metal oxide single crystal particles and said liquid after said metal oxide single crystal particles are aligned along said preferential direction in converting the superconducting metal oxide to a ceramic form.

14. The method of claim 10 wherein said metal oxide has a characteristic critical temperature below which it is superconducting and wherein the step of rendering said metal oxide single crystal particles in a superconducting state includes lowering the temperature of said metal oxide single crystal particles to said characteristic critical temperature.

15. The method of claim 10 wherein said superconducting metal oxide has a characteristic critical temperature below which it is superconducting, said method further comprising the step of using the room temperature paramagnetism of the said superconducting material so as to align in a slip at room temperature and said superconducting metal oxide being yttrium barium copper oxide and wherein the step of converting said superconducting metal oxide to a paramagnetic material includes substantially replacing yttrium atoms in said yttrium barium copper oxide with rare earth atoms.

16. The method of claim 1 wherein the step of orienting said metal oxide crystals along a preferential axis includes directing a plane pressure wave onto the metal oxide powder in orienting said metal oxide single crystal particles along a preferential direction such that said one or more shorter axes of each of said metal oxide crystals are in general alignment.

17. The method of claim 16 further comprising the step of reflecting the plane pressure wave back onto the metal oxide powder after the plane pressure wave initially transits the metal oxide powder in directing a standing plane pressure wave onto the metal oxide powder.

18. A method for forming a superconducting metal oxide comprised of crystals having a nonsymmetric morphology and superconducting anisotropy, said method comprising the steps of:
providing a superconducting metal oxide material in the form of a polycrystalline powder;
pressing said polycrystalline powder into a coherent mass;
sintering said coherent mass; and
reducing said coherent mass to a powder comprised of flake-like, single crystal particles of said superconducting metal oxide.

19. The method of claim 18 wherein the step of sintering said coherent mass includes heating said coherent mass to a temperature on the order of the melting temperature of said superconducting metal oxide material.

20. The method of claim 18 wherein sintering of said coherent mass causes the crystals of the superconducting metal oxide to grow to on the order of X microns in diameter and wherein the step of reducing said coherent mass to a powder includes grinding the coherent mass down to particle sizes on the order of Y microns in diameter, where $Y \ll X$, and wherein the step of grinding the coherent mass includes cleaving the superconducting metal oxide along its crystal axes.

21. The method of claim 18 further comprising the step of adding an impurity having a lower melting point than the metal oxide crystals to the polycrystalline powder prior to pressing the polycrystalline powder to a coherent mass to enhance grain growth of the metal oxide crystals during subsequent sintering of said coherent mass.

22. A superconducting metal oxide comprising:
a plurality of powder particles each comprised of a single crystal of said metal oxide, wherein each of said metal oxide crystal particles is characterized by superconducting anisotropy; and
a plurality of axes each defined along a respective direction in each of said metal oxide crystal particles, and wherein each of said metal oxide crystal particles is superconducting along one or more of said axes and wherein said one or more axes along which each of said metal oxide crystal particles is superconducting are aligned.

23. A superconducting metal oxide as in claim 22 wherein each of said metal oxide crystals is a rare earth metal oxide crystal.

24. A superconducting metal oxide as in claim 23 wherein each of said rare earth metal oxide crystals is a rare earth barium copper oxide crystal.

25. A superconducting metal oxide as in claim 24 wherein each of said rare earth barium oxide crystals is a yttrium barium copper oxide crystal, $YBa_2Cu_3O_{7-x}$, where $0 > x > 0.5$.

26. A superconducting metal oxide as in claim 22 wherein said metal oxide crystal particles are orthorhombic having three mutually orthogonal axes along a-, b- and c-directions, said metal oxide crystal particles being superconducting along said a- and b-directions, said a- and b-directions being co-planar, the two axes in said a- and b-directions being shorter than the axis in said c-direction nd the axes of said metal oxide crystals along said c-direction being parallel.

FIG. 1

FIG. 2

FIG. 3

FIG. 4

FIG. 6

FIG. 5